**Europäisches Patentamt**

**European Patent Office**

**Office européen des brevets**

(19)

(11) Veröffentlichungsnummer: **0 067 337**
**B1**

(12) 

# EUROPÄISCHE PATENTSCHRIFT

(45) Veröffentlichungstag der Patentschrift:
**11.03.87**

(21) Anmeldenummer: **82104674.5**

(22) Anmeldetag: **27.05.82**

(51) Int. Cl.⁴: **G 01 R 33/00,** G 01 R 33/02,
G 01 C 17/28

(54) **Anordnung einer Magnetfeldsonde an einem Fahrzeug.**

(30) Priorität: **11.06.81 DE 3123215**

(43) Veröffentlichungstag der Anmeldung:
**22.12.82 Patentblatt 82/51**

(45) Bekanntmachung des Hinweises auf die Patenterteilung:
**11.03.87 Patentblatt 87/11**

(84) Benannte Vertragsstaaten:
**AT BE CH DE FR GB IT LI NL**

(56) Entgegenhaltungen:
**DE - C - 977 817**
**GB - A - 1 565 188**
**US - A - 2 158 500**
**US - A - 2 418 553**

(73) Patentinhaber: **Siemens Aktiengesellschaft Berlin und München, Wittelsbacherplatz 2, D-8000 München 2 (DE)**

(72) Erfinder: **Scherer, Hartmut, Dipl.-Phys., Tölzer Strasse 37, D-8000 München 70 (DE)**
Erfinder: **Thilo, Peer, Dr.-Ing., Buchhierlstrasse 19, D-8000 München 71 (DE)**

## Beschreibung

Die Erfindung betrifft die Anordnung einer Magnetfeldsonde zur Richtungsbestimmung in einem Kraftfahrzeug mit zumindest teilweise ferromagnetischer Karosserie, wobei die Sonde mindestens zwei zueinander einen Winkel bildende, jeweils eine Wicklung tragende Eisenkernschenkel besitzt.

Eine derartige Sonde mit zwei zueinander im Winkel angeordneten Wicklungen ist beispielsweise aus der DE-A-29 46 640 bekannt. Ausserdem ist die Anordnung einer derartigen Sonde zur Richtungsbestimmung bereits in der US-A-2,158,500 beschrieben. Bei dieser wie auch bei anderen bekannten Magnetfeldsonden werden die Horizontalkomponenten des Erdmagnetfeldes am jeweiligen Standort bestimmt. Allerdings muss dabei Sorge getragen werden, dass möglichst nur der Fluss dieser Horizontalkomponenten des Erdmagnetfeldes auf die Sonde einwirkt. Besitzt das Fahrzeug eine Karosserie aus ferromagnetischem Metall, so ergibt sich das Problem, dass sich das Magnetfeld des Fahrzeugs dem der Erde überlagert. Dies ergibt Fehlanzeigen der Richtung, die im Extremfall dazu führen können, dass stets die gleiche und somit eine falsche Richtung angezeigt wird.

Bei bekannten Anordnungen von Magnetfeldsonden wurde versucht, die auftretende Missweisungen durch Wahl des Einbauortes am Fahrzeug so gering wie möglich zu halten. Dazu ist es im allgemeinen üblich, die Sonde ausserhalb des Fahrzeugs in einiger Entfernung zum Karosserieblech zu montieren. Hierzu wurde beispielsweise ein stabförmiger Halter auf dem Dach oder zumindest in Fensternähe vorgesehen, der den Abstand zum Karosserieblech herstellen sollte. Derartige Anordnungen mit weit über das Fahrzeug hinausstehenden Haltern haben den Nachteil, dass üblicherweise das Dach zur Befestigung des Halters bzw. zur Durchführung von Anschlussleitungen durchbohrt werden muss. Ausserdem sind ausserhalb des Fahrzeugs angebrachte Sonden gefährdet, beispielsweise beim Durchfahren einer Waschanlage; sie sind verschiedentlich auch hinderlich, etwa beim Montieren von Dachgepäckträgern und dergleichen.

In der DE-C-988 817 ist eine Einrichtung zur Kompensation des magnetischen Wirbelstromstörfeldes, das durch einen metallischen Hohlkörper bei dessen Bewegung im Erdfeld entsteht, beschrieben. Diese Einrichtung ist hauptsächlich zum Schutz von Schiffen, insbesondere Unterwasserfahrzeugen, vor magnetischen Minen, magnetischen Torpedos oder dergleichen gedacht. Dabei wird das magnetische Wirbelstromstörfeld mittels zweier senkrecht zueinander angeordneter Induktionsspulen oder ähnlich magnetischer Fühler gemessen und zur Steuerung von Kompensationsspulen, deren magnetische Felder das Störfeld kompensieren, ausgewertet. Eine Anwendung der dort verwendeten Messspulen zur Richtungsbestimmung bei Landfahrzeugen ist jedoch bei dieser Schrift nicht in Betracht gezogen.

Aus der US-A-2, 418, 553 ist ein Flussmesssystem zur Messung von magnetischen Feldern bekannt, wobei beispielsweise das Erdmagnetfeld, insbesondere aber die von Permanentmagneten erzeugten Felder bzw. von einem remanenten Magnetismus in einem Prüfgegenstand erzeugte Felder gemessen werden sollen. Im einzelnen wird dort ein System zur Entmagnetisierung des eisernen Schiffrumpfes von Kriegsschiffen beschrieben, um den remanenten Magnetismus, der gegnerische Minen zum Ansprechen bringen könnte, auszuschalten. Es ist in dieser Schrift zwar auch allgemein davon die Rede, das beschriebene Instrument etwa zur Anzeige des Erdmagnetfeldes zu verwenden, wobei jedoch keine Möglichkeit angegeben wird, dieses Erdmagnetfeld zur Richtungsbestimmung in einem ferromagnetischen Gehäuse, also etwa in einem Fahrzeug, auszunutzen. Da das beschriebene Instrument vornehmlich zur Messung von remanentem Magnetismus geeignet ist, würde es folglich bei unveränderter Anwendung auch in einem Fahrzeug lediglich den dort vorhandenen remanenten Magnetismus bestimmen, wobei das Erdmagnetfeld entweder überhaupt nicht oder nur stark verfälscht in die Messung eingehen würde.

Aufgabe der Erfindung ist es, eine Anordnung für eine Magnetfeldsonde der eingangs genannten Art anzugeben, die möglichst einfach und ohne wesentliche Veränderungen am Fahrzeug selbst vorgenommen werden kann, die keinerlei Behinderungen beim Gebrauch des Fahrzeugs nach sich zieht und trotzdem eine zuverlässige Messung der Fahrtrichtung in Bezug zum Erdmagnetfeld ermöglicht.

Erfindungsgemäss wird diese Aufgabe dadurch gelöst, dass die Sonde unmittelbar an einer ferromagnetischen Aussenwand der Karosserie angebracht und mit dieser starr verbunden ist.

Die Erfindung macht sich die Erkenntnis zunutze, dass eine Metallkarosserie des Fahrzeugs das Erdmagnetfeld nicht nur abschirmt und verzerrt, sondern dass die weichmagnetischen Teile dieser Karosserie auch die Feldlinien des Erdmagnetfeldes sammeln und damit zur Messung dieses Feldes mit herangezogen werden können. Soweit die hartmagnetischen Teile im Fahrzeug eine Verzerrung des Magnetfeldes hervorrufen, können derartige Störungen durch Korrekturverfahren eliminiert werden. Ein derartiges Korrekturverfahren ist beispielsweise in der mit gleicher Priorität angemeldeten EP-A-00 67 338 (veröffentlicht am 22.12.1982) beschrieben. Durch die Anbringung der Magnetfeldsonde am weichmagnetischen Karosserieblech wird dieses gleichsam als Verlängerung der Sonde benutzt. Gemessen wird dann nicht das Erdmagnetfeld in der Luft, sondern dessen Verlauf im Blech. Die weichmagnetischen Teile des Karosserieblechs werden also vom Magnetfeld der Erde aufmagnetisiert, und diese Magnetisierung kann als Mass für die Richtung benutzt werden.

Möglich wäre bei der erfindungsgemässen Anordnung auch eine Anbringung der Sonde an der Karosserieaussenseite. Die Vorteile der Erfindung kommen jedoch besonders zur Geltung, wenn die Sonde im Inneren des Fahrzeuges angebracht wird. Damit vermeidet man Wanddurchbrüche und störende Veränderungen an der Aussenseite. Im Innenraum können Hohlräumen beispielsweise zwischen dem Karosserieblech und der Innenraumbespannung, die Sonde aufnehmen, so dass die Sonde keinen Nutzraum verbraucht und nicht einmal optisch wahrnehmbar ist.

Besonders gute Messergebnisse lassen sich durch symmetrische Anordnung der Sonde an einer weitgehend homogenen Metalloberfläche der Karosserie erzielen. Hierzu eignet sich vor allem das Fahrzeugdach, wo die Sonde zweckmässigerweise etwa mittig angebracht wird. Je nach Art des Fahrzeugs sind auch andere Einbauorte günstig, wie beispielsweise die Kofferraumhaube an einem Kabriolett. Damit behält der Konstrukteur bzw. der Designer des Fahrzeugs genügend Freiraum für eine Unterbringung der Sonde ohne Beschränkung für den Benutzer des Fahrzeugs.

In einer zweckmässigen Ausführungsform ist dabei vorgesehen, dass die Sonde in einem Gehäuse aus nicht ferromagnetischem Material angeordnet ist und dass das Gehäuse seinerseits an der Fahrzeugkarosserie befestigt ist. Diese Befestigung kann in einfachster Weise beispielsweise durch Kleben erfolgen. Das erwähnte Gehäuse kann aus einem beliebigen Isolierstoff oder auch beispielsweise aus Aluminium bestehen. Möglich wäre auch das Vergiessen der Sonde in einem Kunststoffblock.

Die Erfindung wird nachfolgend an einem Ausführungsbeispiel näher erläutert: Es zeigt

Figur 1 und 2 ein Kraftfahrzeug mit einer Magnetsonde in zwei Ansichten,

Figur 3 einen Schnitt durch eine im Fahrzeuginneren angebrachte Magnetfeldsonde.

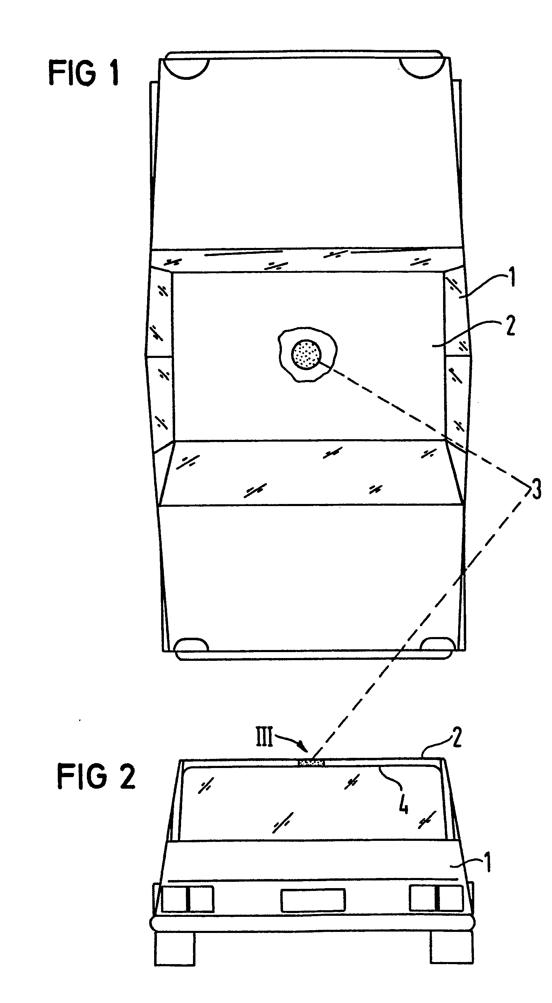

Die Figuren 1 und 2 zeigen ein Kraftfahrzeug 1 mit Blechkarosserie jeweils in einer Ansicht von oben und von hinten. Das Blechdach 2 stellt eine relativ grosse homogene, im wesentlichen weichmagnetische, Fläche dar. Die Magnetfeldsonde 3 ist an der Innenseite des Daches 2 in der Mitte, etwa symmetrisch zur Fläche des Daches 2, angeordnet. Dabei findet die Sonde Platz zwischen dem Blechdach 2 und der Innenraumbespannung 4 des Kraftfahrzeugs.

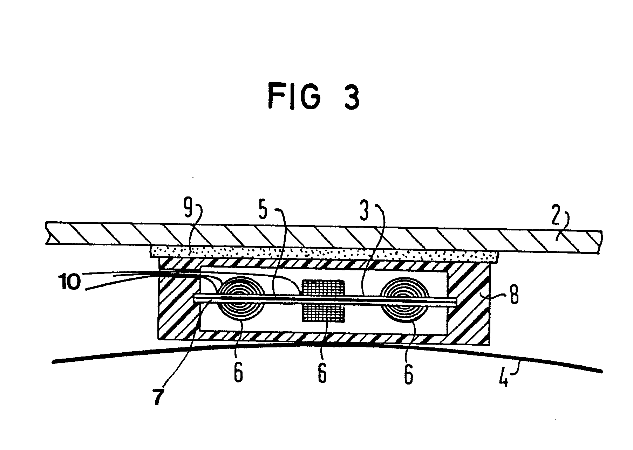

Figur 3 zeigt einen Detailschnitt III aus Figur 2. Die Sonde 3 ist zwischen dem Blechdach 2 des Fahrzeugs und der Innenraumbespannung 4 angeordnet. Sie besteht im wesentlichen aus einem Kernblech 5, welches parallel zum Blechdach 2 angeordnet ist und mehrere zueinander im rechten Winkel stehende Schenkel bildet. Auf jedem Schenkel ist jeweils eine Spulenwicklung 6 angeordnet. Mit Hilfe der durch das Erdmagnetfeld beeinflussten Spuleninduktion kann in bekannten Messverfahren das Magnetfeld und damit die Richtung bestimmt werden.

Die Magnetsonde 3 ist über einen Träger 7 in einem Gehäuse 8 waagerecht aufgehängt. Sowohl der Träger 7 als auch das Gehäuse 8 können aus Plexiglas oder einem sonstigen Kunststoff, aber auch aus nicht ferromagnetischem Material bestehen. Das Gehäuse 8 ist seinerseits mit einem Kleber 9 flach am Autodach 2 befestigt. Dadurch wird die Sonde 3 mit dem Blechkern 5 parallel zur Ebene des Blechdaches 2 gehalten. Der Aufbau einer derartigen Sonde mit Blechkern ist beispielsweise aus der DE-OS 29 46 640 zu ersehen. Die Anschlussdrähte 10 der Spulenwicklungen 6 sind durch das Gehäuse 8 herausgeführt und mit einem an anderer Stelle im Fahrzeug untergebrachten Auswertegerät verbunden.

Eine Sonde dieser Art benötigt sehr wenig Platz; beispielsweise bringt eine Sonde mit einer Höhe von ca. 6 mm und einer Breite von weniger als 30 mm bereits gute Messergebnisse. Soweit die Sonde beim Einbau nicht genau parallel zum Blechdach des Fahrzeugs ausgerichtet wird, können dadurch verursachte Fehler ohne weiteres mit dem erwähnten Korrekturverfahren eliminiert werden.

**Patentansprüche**

1. Anordnung einer Magnetfeldsonde (3) zur Richtungsbestimmung in einem Kraftfahrzeug (1) mit zumindest teilweise ferromagnetischer Karosserie, wobei die Sonde (3) mindestens zwei zueinander einen Winkel bildende, jeweils eine Wicklung (6) tragende Eisenkernschenkel (5) besitzt, dadurch gekennzeichnet, dass die Sonde (3) unmittelbar an einer ferromagnetischen Aussenwand (2) der Karosserie angebracht und mit dieser starr verbunden ist.

2. Anordnung nach Anspruch 1, dadurch gekennzeichnet, dass die Sonde (3) an der Innenseite der Karosseriewand (2) angeordnet ist.

3. Anordnung nach Anspruch 1 oder 2, dadurch gekennzeichnet, dass die Sonde (3) symmetrisch an einer weitgehend homogenen Metalloberfläche (2) der Karosserie angeordnet ist.

4. Anordnung nach einem der Ansprüche 1 bis 3, dadurch gekennzeichnet, dass die Sonde (3) etwa mittig an der Innenseite des Fahrzeugdaches (2) angeordnet ist.

5. Anordnung nach einem der Ansprüche 1 bis 3, dadurch gekennzeichnet, dass die Sonde (3) an der Innenseite des Kofferraumdeckels eines Fahrzeuges angeordnet ist.

6. Anordnung nach einem der Ansprüche 1 bis 5, dadurch gekennzeichnet, dass die Sonde (3) in einem Gehäuse (8) aus nicht ferromagnetischem Material angeordnet ist und dass das Gehäuse (8) seinerseits an der Fahrzeugkarosserie (2) befestigt ist.

7. Anordnung nach Anspruch 6, dadurch gekennzeichnet, dass das Gehäuse (8) am Karosserieblech (2) angeklebt ist.

8. Anordnung nach Anspruch 6 oder 7, dadurch gekennzeichnet, dass die Sonde mit ihrem Kernblech über einen Träger (7) waagerecht im Gehäuse (8) aufgehängt ist.

**Claims**

1. An arrangement of a magnetic field probe (3) for the determination of direction in a motor vehicle (1) with at least partially ferro-magnetic coach-work, wherein the probe (3) possesses at least two iron core flanks (5) which form an angle to one another and respectively support a winding (6), characterised in that the probe (3) is directly fixed to a ferro-magnetic outer wall (2) of the body and is rigidly connected thereto.

2. An arrangement as claimed in claim 1, characterised in that the probe (3) is arranged on the inside of the wall (2) of the body.

3. An arrangement as claimed in claim 1 or 2, characterised in that the probe (3) is symmetrically arranged on a largely homogeneous metal surface (2) of the body.

4. An arrangement as claimed in one of claims 1 to 3, characterised in that the probe (3) is approximately centrally arranged on the inside of the vehicle roof (2).

5. An arrangement as claimed in one of claims 1 to 3, characterised in that the probe (3) is arranged on the inside of the luggage compartment door of a vehicle.

6. An arrangement as claimed in one of claims 1 to 5, characterised in that the probe (3) is arranged in a housing (8) made of a non-ferro-magnetic material and that the housing (8) is in turn secured to the vehicle body. (2).

7. An arrangement as claimed in claim 6, characterised in that the housing (8) is connected to the body panel (2) by adhesion.

8. An arrangement as claimed in claim 6 or 7, characterised in that the probe has its core sheet horizontally suspended in the housing (8) by means of a carrier (7).

**Revendications**

1. Installation de sonde de champ magnétique (3) servant à déterminer une direction dans un véhicule automobile (1) possédant une carrosserie au moins partiellement ferromagnétique, la sonde (3) possédant un noyau de fer comportant au moins deux branches (5) faisant un angle entre elles et portant chacune un enroulement (6), caractérisée par le fait que la sonde (3) est montée directement sur une paroi extérieure ferromagnétique (2) de la carrosserie et est reliée rigidement à cette dernière.

2. Installation selon la revendication 1, caractérisée en ce que la sonde (3) est disposée sur la face intérieure de la paroi (2) de la carrosserie.

3. Installation suivant la revendication 1 ou 2, caractérisée par le fait que la sonde (3) est disposée symétriquement sur une surface métallique (2), dans une large mesure homogène, de la carrosserie.

4. Installation suivant l'une des revendications 1 à 3, caractérisée par le fait que la sonde (3) est disposée approximativement au centre de la face intérieure du toit (2) du véhicule.

5. Installation suivant l'une des revendications 1 à 3, caractérisée par le fait que la sonde (3) est disposée sur la face intérieure du couvercle du coffre à bagages d'un véhicule.

6. Installation suivant l'une des revendications 1 à 5, caractérisée par le fait que la sonde (3) est disposée dans un boîtier (8) constitué en un matériau non ferromagnétique et que le boîtier (8) est fixé pour sa part à la carrosserie (2) du véhicule.

7. Installation suivant la revendication 6, caractérisée par le fait que le boîtier (8) est collé à la tôle de la carrosserie (2).

8. Dispositif suivant la revendication 6 ou 7, caractérisé par le fait que la sonde est suspendue horizontalement par la tôle de son noyau, par l'intermédiaire d'un support (7), dans le boîtier (8).

**FIG 1**

1

2

3

**FIG 2**

III

2

4

1

# FIG 3